# EUROPÄISCHE PATENTANMELDUNG

(11) **EP 2 213 759 A1**
(43) Veröffentlichungstag der Anmeldung: **04.08.2010**
(21) Anmeldenummer: 09000151.2
(22) Anmeldetag: 08.01.2009
(51) Int. Cl.: C23C 4/08, C23C 24/04, F01D 5/28, F01D 25/00

(54) **Verfahren zum Beschichten eines Bauteils mit Filmkühllöchern, und Bauteil**

(71) Anmelder: Siemens Aktiengesellschaft, 80333 München (DE)
(72) Erfinder: Bolz, Andrea, 13591 Berlin (DE); Ladru, Francis-Jurjen, Dr., 13587 Berlin (DE); Stadelmaier, Falk, 5400 Baden (CH)

(57) **Zusammenfassung**

Bei der vollständigen Maskierung von Filmkühllöchern bei einer Beschichtung eines Bauteils mit Filmkühllöchern entstehen oft Probleme bei dem Austritt des Kühlgases aus dem Filmkühlloch.

Das erfindungsgemäße Verfahren schlägt vor, die Maskierung nur partiell auszuführen, so dass ein Teil der Beschichtung in dem Filmkühlloch vorhanden ist, wodurch die Strömung sich weiterhin wie ein Film auf dem Bauteil ausbilden kann.

## Beschreibung

Die Erfindung betrifft die partielle Maskierung von Filmkühllöchern und damit hergestellte Bauteile.

Thermisch hoch belastete Bauteile, wie Turbinenschaufeln, weisen oft Filmkühlbohrungen auf, aus denen Luft oder Dampf ausströmt, der einen schützenden Luft- oder Gasfilm auf der Turbinenschaufel bildet. Dabei weist das Filmkühlloch einen Diffusor auf, also einen abflachenden Bereich, so dass auch kein Abriss der Luftströmung stattfindet.

Probleme ergeben sich bei der Beschichtung von Turbinenschaufeln mit bereits vorhandenen Filmkühllöchern, bei denen die Beschichtung aus der Stand der Technik zu Problemen führt.

Es ist daher Aufgabe der Erfindung dieses Problem zu lösen. Die Aufgabe wird gelöst durch ein Verfahren gemäß Anspruch 1 und ein Bauteil gemäß Anspruch 10.

In den Unteransprüchen sind weitere vorteilhafte Ausgestaltungen aufgelistet, die beliebig miteinander kombiniert werden können, um weitere Vorteile zu erzielen.

### Es zeigen:

- Figur 1, 4, 6 - 9: verschiedene Ansichten von Ausführungsbeispielen eines Filmkühllochs mit Maskierung,
- Figur 2, 3: Beispiele für Diffusoren,
- Figur 5: ein Bauteil mit einer Beschichtung im Diffusor,
- Figur 10: eine Gasturbine,
- Figur 11: eine Turbinenschaufel und
- Figur 12: eine Brennkammer.

Die Beschreibung und die Figuren stellen nur Ausführungsbeispiele der Erfindung dar.

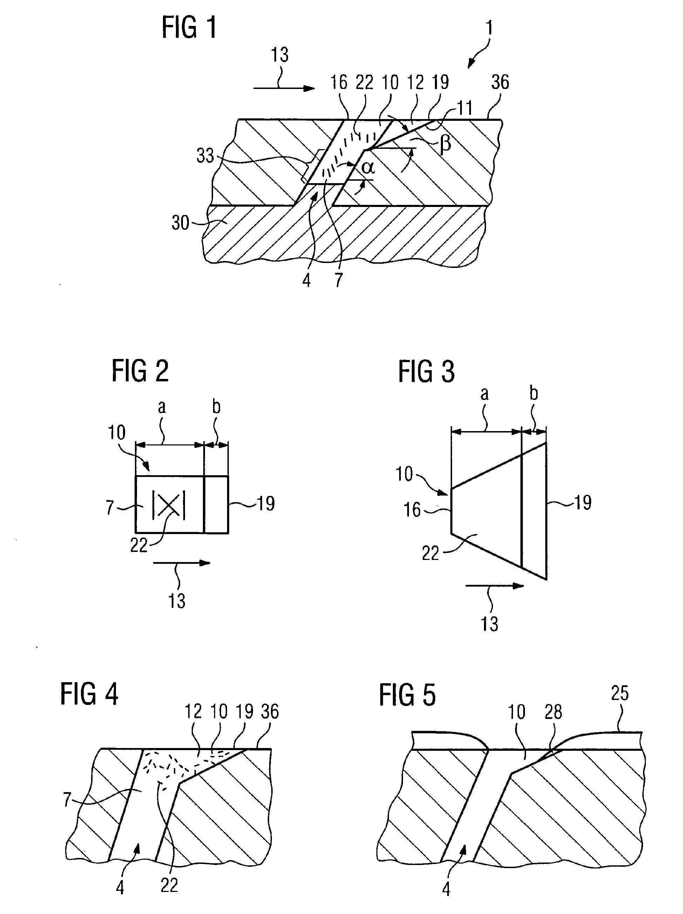

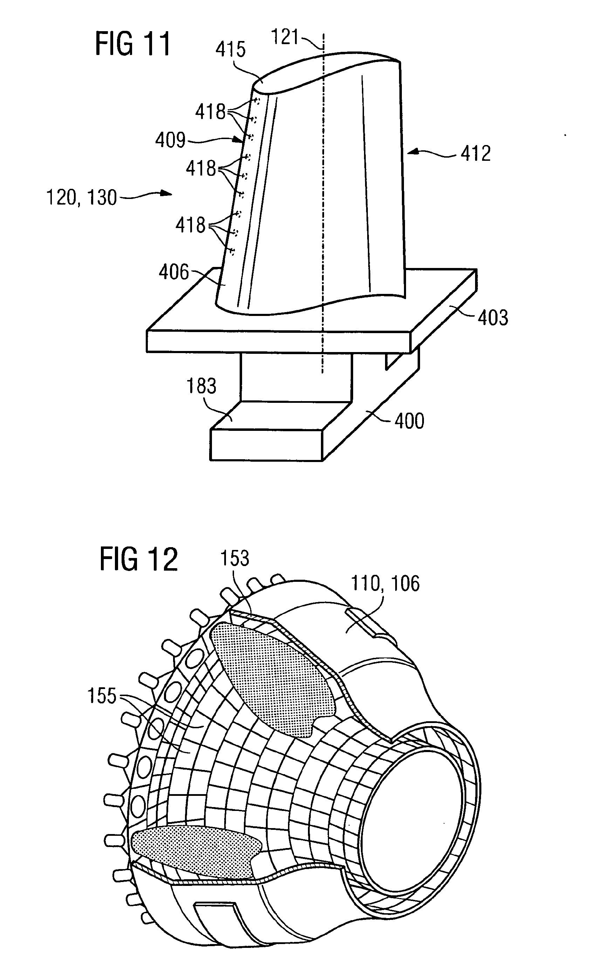

In Figur 1 ist ein Filmkühlloch 4 eines Substrats eines Bauteils 1, 120, 130 (Figur 11), 155 (Figur 12) gezeigt.

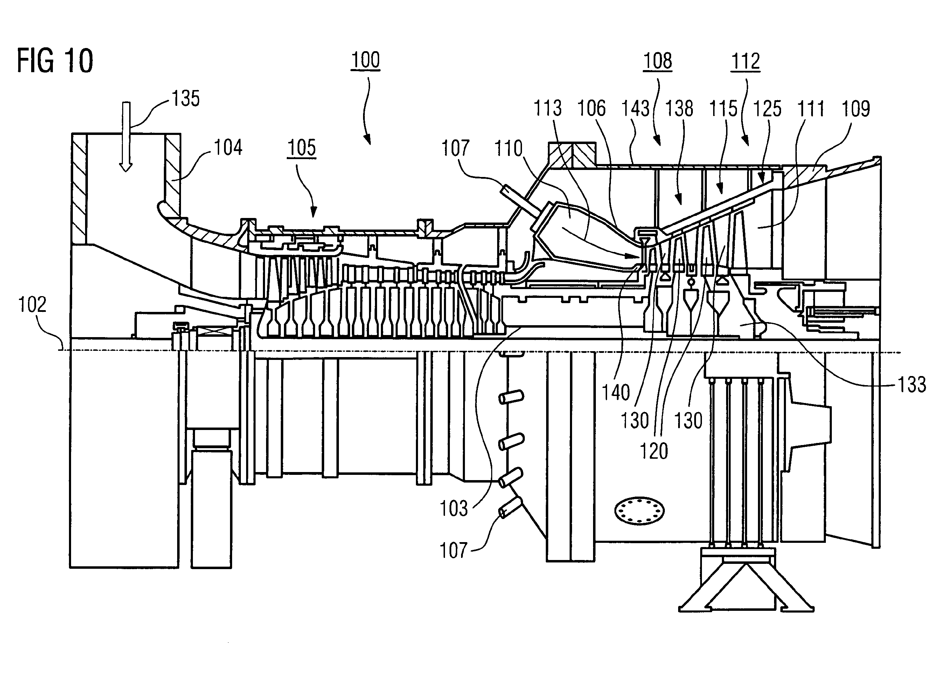

Das Bauteil 1 ist vorzugsweise eine Turbinenschaufel 120, 130 einer Gasturbine 100 (Figur 10).

Das Filmkühlloch 4 weist einen inneren, vorzugsweise zylindrischen Anteil 7 auf. Der innere Anteil 7 beginnt im Hohlraum 30 bis zum Diffusor 10 (4 = 7 + 10). Der innere Anteil 7 hat vorzugsweise einen konstanten Querschnitt.
Das Filmkühlloch 4 weist auch einen äußeren Diffusor 10 auf, der von der Geometrie des inneren Bereichs 7 abweicht, d.h. sich im Querschnitt zur äußeren Oberfläche 36 vergrößert.
Der Diffusor 10 ist insbesondere auch gekennzeichnet durch eine Verbreiterung der Querschnittsöffnung quer zu einer Strömungsrichtung 13 eines Heißgases, das an dem Bauteil 1 vorbeiströmt (Fig. 3). Der Diffusor 10 stellt die gesamte Begrenzung des Filmkühllochs 4 nach außen hin dar.

Der Diffusor 10 weist in Strömungsrichtung 13 (parallel zur Oberfläche 36 des Substrats) gesehen also ein Ende 19 auf, dessen Bereich flacher zur Oberfläche 36 verläuft, als im zylindrischen Anteil 7 des Filmkühllochs 4, d.h. der Neigungswinkel β im Diffusor 10 zur Oberfläche 36 ist kleiner als der Winkel α im zylindrischen Anteil 7.
Es gibt vorzugsweise nur eine Neigung α im zylindrischen Anteil 7 und vorzugsweise nur eine Neigung β im Diffusor 10. Insbesondere gibt es keine weitere Stufe im Bereich mit der Neigung β. Die Innenfläche 11 des Diffusors 10 verläuft geradlinig, weist also keinen Absatz oder Vertiefung auf.

Soll ein Bauteil 1, 120, 130, 155 beschichtet werden, so wird in das Filmkühlloch 4 und damit in den Diffusor 10 ein Maskierungsmaterial 22, insbesondere ein Polymer eingebracht. Das Polymer kann Keramiken oder Verstärkungspartikel enthalten und/oder vor dem Beschichten ausgehärtet (durch UV) werden.

Vorzugsweise wird das Polymer nur partiell in das Filmkühlloch 4 eingebracht. Dabei wird vorzugsweise ein oberer Teil 33 des inneren Anteils 7 des Filmkühllochs 4 vollständig mit dem Polymer ausgefüllt, wohingegen der Diffusor 10 nur partiell gefüllt wird. Am Ende 19 des Diffusors 10 ist also vorzugsweise kein Maskierungsmaterial 22 (Polymer) vorhanden. Das Maskierungsmaterial 22 gelangt aber dort, wo es eingebracht wird, vorzugsweise mindestens bis zur Höhe der äußeren Oberfläche 36 des Substrats 30 (Fig. 1).

Der größte Teil des Polymers (Maskierungsmaterial 22) ist im Filmkühlloch 4 angeordnet und zum kleineren Anteil oder vorzugsweise gar nicht im inneren Hohlraum 30 des Bauteils 1, 120, 130, 155 mit den Filmkühllöchern 4, die in den Hohlraum 30 münden.
Vorzugsweise ist das Maskierungsmaterial 22 nur im Filmkühlloch 4 vorhanden.

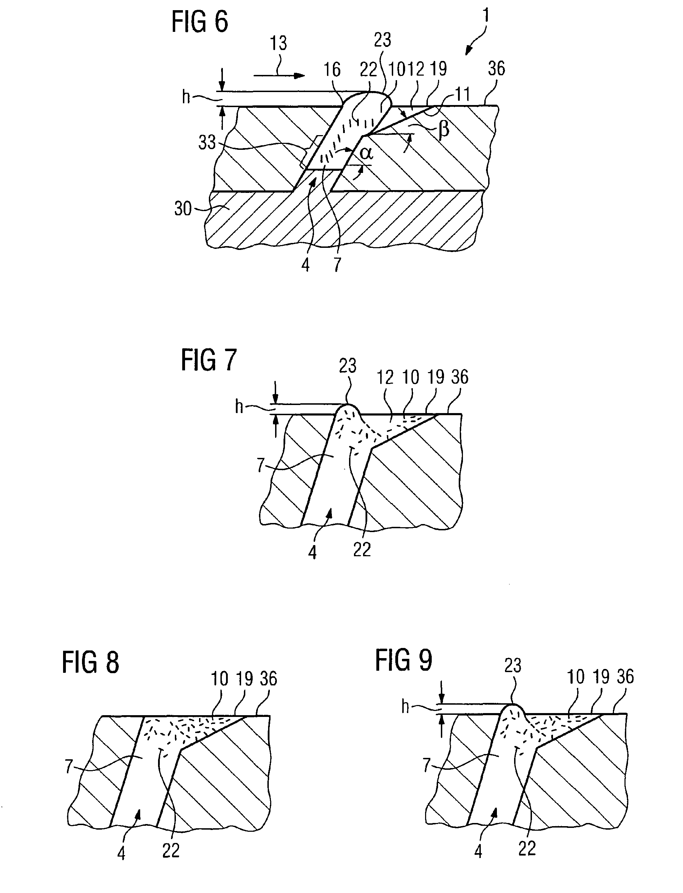

Es verbleibt also ein Freiraum 12 im Filmkühlloch 4 am Ende 19 unterhalb der gedachten fortgesetzten Ebene der äußeren Oberfläche 36, in der keine Maskierung 22 vorhanden ist.
Die Maskierung 22 kann oberhalb des zylindrischen Anteils auch vorzugsweise über die Oberfläche 36 herausragen (Fig. 6) und hat dann vorzugsweise eine Höhe h, die der aufzubringenden Beschichtung entspricht oder vorzugsweise höher.

In Figur 2 ist eine Aufsicht auf Figur 1 gezeigt, in der die Öffnung des Filmkühllochs 4 zu sehen ist.
Die Gesamtlänge des Filmkühllochs 4 in Strömungsrichtung 13 gesehen beträgt a + b.
Über die Länge a ist eine Maskierung 22 vorhanden, wobei in der der Strecke b keine Maskierung vorhanden ist. Das Verhältnis von a:b beträgt vorzugsweise 2:1.

In Figur 3 ist ein weiteres Ausführungsbeispiel eines Diffusors 10 gezeigt.
Der Diffusor 10 verbreitert sich auch quer zur Strömungsrichtung 13. Aber auch hier ist das Polymer nur teilweise vorhanden, d.h. am Ende 19 des Diffusors 10 ist kein Polymer vorhanden. Die Breite des Bereichs innerhalb des Diffusors 10, wo kein Polymer vorhanden ist, ist die Länge b.

Ebenso kann über die Länge b das Polymer nur dünn aufgetragen sein, so dass es am Anfang des Beschichtungsverfahrens noch vorhanden ist, aber durch Erosion und/oder Wärmeeinwirkung abgetragen wird und so eine Beschichtung im Diffusor 10 erst dann möglich wird (Figur 4).
Auch hier verbleibt ein Freiraum 12 im Filmkühlloch 4 unterhalb der äußeren Oberfläche 36. Die Maskierung 22 im Diffusor 10 erstreckt sich hier nicht bis zur Oberfläche 36. Auch hier kann vorzugsweise oberhalb des zylindrischen Anteils 7 das Maskierungsmaterial 22 über die Oberfläche 36 des Substrats herausragen (Fig. 7).

Wenn im Diffusor nur wenig Maskierungsmaterial 22 verwendet wurde (Fig. 4, 7), so wird dieses durch Erosion und/oder Wärmeeinwirkung beim Beschichten abgetragen und der Diffusor 10 wird während des Beschichtungsvorgangs des Bauteils 1 zeitweise noch mitbeschichtet, wodurch die Schichtdicke im Diffusor 10 dünner ist als auf der Oberfläche 36.

Ebenso vorzugsweise kann der Diffusor 10 auch vollständig mindestens bis zur Oberfläche 36 mit Maskierungsmaterial 22 gefüllt sein (Fig. 8, 9). Dadurch, dass der Diffusor 10 am Ende 19 flach verläuft, erodiert dort durch thermischen Angriff (Abschmelze/Dampf) das Maskierungsmaterial 22 während des Beschichtens schneller und der Diffusor 10 kann am Ende 19 beschichtet werden. Gegebenenfalls wird das Polymer am Ende 19 weniger stark ausgehärtet, um dort eine höhere Abtragungsrate zu erreichen.

In Figur 5 ist ein Filmkühlloch 4 nach einer Beschichtung gezeigt, das vorzugsweise eine Polymermaskierung gemäß Figur 1, 2, 3, 4, 6, 7, 8 oder 9 aufwies.
Da am Ende 19 des Diffusors 10 keine oder wenig Maskierung vorhanden war, scheidet sich dort beim Beschichten des Bauteils 1, 120, 130, 155 mit dem Filmkühlloch 4 ein Teil 28 der Beschichtung 25 ab. So entsteht ein sanfter Übergang für das aufströmende Gasstation innerhalb des Filmkühllochs 4 im Diffusor 10 und außerhalb des Filmkühllochs 4 reißt der Luftstrom nicht ab.
Die Beschichtung 28 erstreckt sich vorzugsweise nur im Diffusor und ganz insbesondere nur teilweise im Diffusor 10, also mit deutlichem Abstand zum Übergang des inneren Teils 7. Vorzugsweise nimmt die Schichtdicke der Beschichtung (28) in Richtung des inneren Anteils 7 ab.

Die Figur 8 zeigt beispielhaft eine Gasturbine 100 in einem Längsteilschnitt.
Die Gasturbine 100 weist im Inneren einen um eine Rotationsachse 102 drehgelagerten Rotor 103 mit einer Welle 101 auf, der auch als Turbinenläufer bezeichnet wird.
Entlang des Rotors 103 folgen aufeinander ein Ansauggehäuse 104, ein Verdichter 105, eine beispielsweise torusartige Brennkammer 110, insbesondere Ringbrennkammer, mit mehreren koaxial angeordneten Brennern 107, eine Turbine 108 und das Abgasgehäuse 109.
Die Ringbrennkammer 110 kommuniziert mit einem beispielsweise ringförmigen Heißgaskanal 111. Dort bilden beispielsweise vier hintereinander geschaltete Turbinenstufen 112 die Turbine 108.
Jede Turbinenstufe 112 ist beispielsweise aus zwei Schaufelringen gebildet. In Strömungsrichtung eines Arbeitsmediums 113 gesehen folgt im Heißgaskanal 111 einer Leitschaufelreihe 115 eine aus Laufschaufeln 120 gebildete Reihe 125.

Die Leitschaufeln 130 sind dabei an einem Innengehäuse 138 eines Stators 143 befestigt, wohingegen die Laufschaufeln 120 einer Reihe 125 beispielsweise mittels einer Turbinenscheibe 133 am Rotor 103 angebracht sind.
An dem Rotor 103 angekoppelt ist ein Generator oder eine Arbeitsmaschine (nicht dargestellt).

Während des Betriebes der Gasturbine 100 wird vom Verdichter 105 durch das Ansauggehäuse 104 Luft 135 angesaugt und verdichtet. Die am turbinenseitigen Ende des Verdichters 105 bereitgestellte verdichtete Luft wird zu den Brennern 107 geführt und dort mit einem Brennmittel vermischt. Das Gemisch wird dann unter Bildung des Arbeitsmediums 113 in der Brennkammer 110 verbrannt. Von dort aus strömt das Arbeitsmedium 113 entlang des Heißgaskanals 111 vorbei an den Leitschaufeln 130 und den Laufschaufeln 120. An den Laufschaufeln 120 entspannt sich das Arbeitsmedium 113 impulsübertragend, so dass die Laufschaufeln 120 den Rotor 103 antreiben und dieser die an ihn angekoppelte Arbeitsmaschine.

Die dem heißen Arbeitsmedium 113 ausgesetzten Bauteile unterliegen während des Betriebes der Gasturbine 100 thermischen Belastungen. Die Leitschaufeln 130 und Laufschaufeln 120 der in Strömungsrichtung des Arbeitsmediums 113 gesehen ersten Turbinenstufe 112 werden neben den die Ringbrennkammer 110 auskleidenden Hitzeschildelementen am meisten thermisch belastet.
Um den dort herrschenden Temperaturen standzuhalten, können diese mittels eines Kühlmittels gekühlt werden.
Ebenso können Substrate der Bauteile eine gerichtete Struktur aufweisen, d.h. sie sind einkristallin (SX-Struktur) oder weisen nur längsgerichtete Körner auf (DS-Struktur).
Als Material für die Bauteile, insbesondere für die Turbinenschaufel 120, 130 und Bauteile der Brennkammer 110 werden beispielsweise eisen-, nickel- oder kobaltbasierte Superlegierungen verwendet.

Solche Superlegierungen sind beispielsweise aus der EP 1 204 776 B1, EP 1 306 454, EP 1 319 729 A1, WO 99/67435 oder WO 00/44949 bekannt.

Ebenso können die Schaufeln 120, 130 Beschichtungen gegen Korrosion (MCrA1X; M ist zumindest ein Element der Gruppe Eisen (Fe), Kobalt (Co), Nickel (Ni), X ist ein Aktivelement und steht für Yttrium (Y) und/oder Silizium, Scandium (Sc) und/oder zumindest ein Element der Seltenen Erden bzw. Hafnium). Solche Legierungen sind bekannt aus der EP 0 486 489 B1, EP 0 786 017 B1, EP 0 412 397 B1 oder EP 1 306 454 A1.

Auf der MCrA1X kann noch eine Wärmedämmschicht vorhanden sein, und besteht beispielsweise aus ZrO₂, Y₂O₃-ZrO₂, d.h. sie ist nicht, teilweise oder vollständig stabilisiert durch Yttriumoxid und/oder Kalziumoxid und/oder Magnesiumoxid.
Durch geeignete Beschichtungsverfahren wie z.B. Elektronenstrahlverdampfen (EB-PVD) werden stängelförmige Körner in der Wärmedämmschicht erzeugt.

Die Leitschaufel 130 weist einen dem Innengehäuse 138 der Turbine 108 zugewandten Leitschaufelfuß (hier nicht dargestellt) und einen dem Leitschaufelfuß gegenüberliegenden Leitschaufelkopf auf. Der Leitschaufelkopf ist dem Rotor 103 zugewandt und an einem Befestigungsring 140 des Stators 143 festgelegt.

Die Figur 9 zeigt in perspektivischer Ansicht eine Laufschaufel 120 oder Leitschaufel 130 einer Strömungsmaschine, die sich entlang einer Längsachse 121 erstreckt.

Die Strömungsmaschine kann eine Gasturbine eines Flugzeugs oder eines Kraftwerks zur Elektrizitätserzeugung, eine Dampfturbine oder ein Kompressor sein.

Die Schaufel 120, 130 weist entlang der Längsachse 121 aufeinander folgend einen Befestigungsbereich 400, eine daran angrenzende Schaufelplattform 403 sowie ein Schaufelblatt 406 und eine Schaufelspitze 415 auf.
Als Leitschaufel 130 kann die Schaufel 130 an ihrer Schaufelspitze 415 eine weitere Plattform aufweisen (nicht dargestellt).

Im Befestigungsbereich 400 ist ein Schaufelfuß 183 gebildet, der zur Befestigung der Laufschaufeln 120, 130 an einer Welle oder einer Scheibe dient (nicht dargestellt).
Der Schaufelfuß 183 ist beispielsweise als Hammerkopf ausgestaltet. Andere Ausgestaltungen als Tannenbaum- oder Schwalbenschwanzfuß sind möglich.
Die Schaufel 120, 130 weist für ein Medium, das an dem Schaufelblatt 406 vorbeiströmt, eine Anströmkante 409 und eine Abströmkante 412 auf.

Bei herkömmlichen Schaufeln 120, 130 werden in allen Bereichen 400, 403, 406 der Schaufel 120, 130 beispielsweise massive metallische Werkstoffe, insbesondere Superlegierungen verwendet.
Solche Superlegierungen sind beispielsweise aus der EP 1 204 776 B1, EP 1 306 454, EP 1 319 729 A1, WO 99/67435 oder WO 00/44949 bekannt.
Die Schaufel 120, 130 kann hierbei durch ein Gussverfahren, auch mittels gerichteter Erstarrung, durch ein Schmiedeverfahren, durch ein Fräsverfahren oder Kombinationen daraus gefertigt sein.

Werkstücke mit einkristalliner Struktur oder Strukturen werden als Bauteile für Maschinen eingesetzt, die im Betrieb hohen mechanischen, thermischen und/oder chemischen Belastungen ausgesetzt sind.
Die Fertigung von derartigen einkristallinen Werkstücken erfolgt z.B. durch gerichtetes Erstarren aus der Schmelze. Es handelt sich dabei um Gießverfahren, bei denen die flüssige metallische Legierung zur einkristallinen Struktur, d.h. zum einkristallinen Werkstück, oder gerichtet erstarrt.

Dabei werden dendritische Kristalle entlang dem Wärmefluss ausgerichtet und bilden entweder eine stängelkristalline Kornstruktur (kolumnar, d.h. Körner, die über die ganze Länge des Werkstückes verlaufen und hier, dem allgemeinen Sprachgebrauch nach, als gerichtet erstarrt bezeichnet werden) oder eine einkristalline Struktur, d.h. das ganze Werkstück besteht aus einem einzigen Kristall. In diesen Verfahren muss man den Übergang zur globulitischen (polykristallinen) Erstarrung meiden, da sich durch ungerichtetes Wachstum notwendigerweise transversale und longitudinale Korngrenzen ausbilden, welche die guten Eigenschaften des gerichtet erstarrten oder einkristallinen Bauteiles zunichte machen.
Ist allgemein von gerichtet erstarrten Gefügen die Rede, so sind damit sowohl Einkristalle gemeint, die keine Korngrenzen oder höchstens Kleinwinkelkorngrenzen aufweisen, als auch Stängelkristallstrukturen, die wohl in longitudinaler Richtung verlaufende Korngrenzen, aber keine transversalen Korngrenzen aufweisen. Bei diesen zweitgenannten kristallinen Strukturen spricht man auch von gerichtet erstarrten Gefügen (directionally solidified structures). Solche Verfahren sind aus der US-PS 6,024,792 und der EP 0 892 090 A1 bekannt.

Ebenso können die Schaufeln 120, 130 Beschichtungen gegen Korrosion oder Oxidation aufweisen, z. B. (MCrA1X; M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden, bzw. Hafnium (Hf)). Solche Legierungen sind bekannt aus der EP 0 486 489 B1, EP 0 786 017 B1, EP 0 412 397 B1 oder EP 1 306 454 A1.
Die Dichte liegt vorzugsweise bei 95% der theoretischen Dichte.
Auf der MCrA1X-Schicht (als Zwischenschicht oder als äußerste Schicht) bildet sich eine schützende Aluminiumoxidschicht (TGO = thermal grown oxide layer).

Vorzugsweise weist die Schichtzusammensetzung Co-30Ni-28Cr-8A1-0,6Y-0,7Si oder Co-28Ni-24Cr-10A1-0,6Y auf. Neben diesen kobaltbasierten Schutzbeschichtungen werden auch vorzugsweise nickelbasierte Schutzschichten verwendet wie Ni-10Cr-12Al-0,6Y-3Re oder Ni-12Co-21Cr-11A1-0,4Y-2Re oder Ni-25Co-17Cr-10A1-0,4Y-1,5Re.

Auf der MCrA1X kann noch eine Wärmedämmschicht vorhanden sein, die vorzugsweise die äußerste Schicht ist, und besteht beispielsweise aus ZrO₂, Y₂O₃-ZrO₂, d.h. sie ist nicht, teilweise oder vollständig stabilisiert durch Yttriumoxid und/oder Kalziumoxid und/oder Magnesiumoxid.
Die Wärmedämmschicht bedeckt die gesamte MCrA1X-Schicht. Durch geeignete Beschichtungsverfahren wie z.B. Elektronenstrahlverdampfen (EB-PVD) werden stängelförmige Körner in der Wärmedämmschicht erzeugt.
Andere Beschichtungsverfahren sind denkbar, z.B. atmosphärisches Plasmaspritzen (APS), LPPS, VPS oder CVD. Die Wärmedämmschicht kann poröse, mikro- oder makrorissbehaftete Körner zur besseren Thermoschockbeständigkeit aufweisen. Die Wärmedämmschicht ist also vorzugsweise poröser als die MCrA1X-Schicht.

Wiederaufarbeitung (Refurbishment) bedeutet, dass Bauteile 120, 130 nach ihrem Einsatz gegebenenfalls von Schutzschichten befreit werden müssen (z.B. durch Sandstrahlen). Danach erfolgt eine Entfernung der Korrosions- und/oder Oxidationsschichten bzw. -produkte. Gegebenenfalls werden auch noch Risse im Bauteil 120, 130 repariert. Danach erfolgt eine Wiederbeschichtung des Bauteils 120, 130 und ein erneuter Einsatz des Bauteils 120, 130.

Die Schaufel 120, 130 kann hohl oder massiv ausgeführt sein. Wenn die Schaufel 120, 130 gekühlt werden soll, ist sie hohl und weist ggf. noch Filmkühllöcher 418 (gestrichelt angedeutet) auf.

Die Figur 10 zeigt eine Brennkammer 110 einer Gasturbine.
Die Brennkammer 110 ist beispielsweise als so genannte Ringbrennkammer ausgestaltet, bei der eine Vielzahl von in Umfangsrichtung um eine Rotationsachse 102 herum angeordneten Brennern 107 in einen gemeinsamen Brennkammerraum 154 münden, die Flammen 156 erzeugen. Dazu ist die Brennkammer 110 in ihrer Gesamtheit als ringförmige Struktur ausgestaltet, die um die Rotationsachse 102 herum positioniert ist.

Zur Erzielung eines vergleichsweise hohen Wirkungsgrades ist die Brennkammer 110 für eine vergleichsweise hohe Temperatur des Arbeitsmediums M von etwa 1000°C bis 1600°C ausgelegt. Um auch bei diesen, für die Materialien ungünstigen Betriebsparametern eine vergleichsweise lange Betriebsdauer zu ermöglichen, ist die Brennkammerwand 153 auf ihrer dem Arbeitsmedium M zugewandten Seite mit einer aus Hitzeschildelementen 155 gebildeten Innenauskleidung versehen.
Jedes Hitzeschildelement 155 aus einer Legierung ist arbeitsmediumsseitig mit einer besonders hitzebeständigen Schutzschicht (MCrA1X-Schicht und/oder keramische Beschichtung) ausgestattet oder ist aus hochtemperaturbeständigem Material (massive keramische Steine) gefertigt.
Diese Schutzschichten können ähnlich der Turbinenschaufeln sein, also bedeutet beispielsweise MCrA1X: M ist zumindest ein Element der Gruppe Eisen (Fe), Kobalt (Co), Nickel (Ni), X ist ein Aktivelement und steht für Yttrium (Y) und/oder Silizium und/oder zumindest ein Element der Seltenen Erden, bzw. Hafnium (Hf). Solche Legierungen sind bekannt aus der EP 0 486 489 B1, EP 0 786 017 B1, EP 0 412 397 B1 oder EP 1 306 454 A1.

Auf der MCrA1X kann noch eine beispielsweise keramische Wärmedämmschicht vorhanden sein und besteht beispielsweise aus ZrO₂, Y₂O₃-ZrO₂, d.h. sie ist nicht, teilweise oder vollständig stabilisiert durch Yttriumoxid und/oder Kalziumoxid und/oder Magnesiumoxid.

Durch geeignete Beschichtungsverfahren wie z.B. Elektronenstrahlverdampfen (EB-PVD) werden stängelförmige Körner in der Wärmedämmschicht erzeugt.
Andere Beschichtungsverfahren sind denkbar, z.B. atmosphärisches Plasmaspritzen (APS), LPPS, VPS oder CVD. Die Wärmedämmschicht kann poröse, mikro- oder makrorissbehaftete Körner zur besseren Thermoschockbeständigkeit aufweisen.

Wiederaufarbeitung (Refurbishment) bedeutet, dass Hitzeschildelemente 155 nach ihrem Einsatz gegebenenfalls von Schutzschichten befreit werden müssen (z.B. durch Sandstrahlen). Danach erfolgt eine Entfernung der Korrosions- und/oder Oxidationsschichten bzw. -produkte. Gegebenenfalls werden auch noch Risse in dem Hitzeschildelement 155 repariert. Danach erfolgt eine Wiederbeschichtung der Hitzeschildelemente 155 und ein erneuter Einsatz der Hitzeschildelemente 155.

Aufgrund der hohen Temperaturen im Inneren der Brennkammer 110 kann zudem für die Hitzeschildelemente 155 bzw. für deren Halteelemente ein Kühlsystem vorgesehen sein. Die Hitzeschildelemente 155 sind dann beispielsweise hohl und weisen ggf. noch in den Brennkammerraum 154 mündende Kühllöcher (nicht dargestellt) auf.

## Patentansprüche

1. Verfahren zum Beschichten eines Substrats (30) mit einem Filmkühlloch (4),
bei dem das Filmkühlloch (4) einen Diffusor (10) aufweist, mit einem Anfang (16) und einem Ende (19) in einer Strömungsrichtung (13) gesehen,
wobei vor dem Beschichten zumindest teilweise eine Maskierung (22) in das Filmkühlloch (4) eingebracht wird,
wobei im Diffusor (10) am Ende (19) kein oder wenig Maskierungsmaterial (22) vorhanden ist,
und in dem restlichen Bereich des Filmkühllochs (4) Maskierungsmaterial (22) vorhanden ist,
Beschichten des Substrats (30) mit der Maskierung (22).

2. Verfahren nach Anspruch 1,
wobei in Strömungsrichtung (13) gesehen der Diffusor (10) eine Ausdehnung (a + b) aufweist, und
wobei nur im Bereich mit der Länge (b) vom Ende (19) her des Diffusors (10) kein Maskierungsmaterial (22) im Diffusor (10) vorhanden ist.

3. Verfahren nach Anspruch 1 oder 2,
bei dem die Maskierung (22) sich über mindestens 60% der Länge (a + b) im Diffusor (10) erstreckt.

4. Verfahren nach Anspruch 1, 2 oder 3,
bei dem das Maskierungsmaterial (22) zum größten Teil im inneren, insbesondere zylindrischen Teil (7) des Filmkühllochs (4) angeordnet ist.

5. Verfahren nach Anspruch 2 oder 3,
bei dem das Verhältnis von a:b gleich 2:1 beträgt.

6. Verfahren nach Anspruch 1, 2, 3 oder 4,
bei dem als Maskierungsmaterial (22) ein Polymer verwendet wird,
insbesondere mit anorganischem Füllmaterial.

7. Verfahren nach Anspruch 1, 2, 3, 4 oder 5,
bei dem am Ende (19) des Filmkühllochs (4) keine Maskierung eingebracht wird.

8. Verfahren nach Anspruch 1, 2, 3, 4 oder 6,
bei dem das Maskierungsmaterial (22) in das Filmkühlloch (4) am Ende (19) des Diffusors (10) eingebracht wird, aber nicht bis zur Oberfläche (36) des Substrats oder einer bereits vorhandenen Beschichtung auf dem Substrat außerhalb des Filmkühllochs (4).

9. Verfahren nach Anspruch 1, 2, 3, 4, 5 oder 7,
bei dem das Maskierungsmaterial (22) über die äußere Oberfläche (36) des Bauteils (120, 130, 155) oder über eine bereits vorhandene Beschichtung auf dem Substrat außerhalb des Filmkühllochs (4) hinausragt,
insbesondere nur in einem inneren Anteil (7) des Filmkühllochs (4).

10. Bauteil,
insbesondere hergestellt nach Anspruch 1, 2, 3, 4, 5, 6, 7, 8 oder 9,
bei dem eine Beschichtung (28) zumindest teilweise in den Diffusor (10) des Filmkühllochs (4) hineinragt und höchstens teilweise im Diffusor (10) vorhanden ist.

11. Bauteil nach Anspruch 10,
bei dem an einem ersten Ende (16) des Filmkühllochs (4) keine Beschichtung vorhanden ist.

12. Bauteil nach Anspruch 10 oder 11,
bei dem die Beschichtung (25) nur im Diffusor (10) und insbesondere höchstens teilweise im Diffusor (10) angeordnet ist,
ganz insbesondere die Schichtdicke der Beschichtung (28) im Diffusor (10) in Richtung des inneren, insbesondere zylindrischen Anteils (7) abnimmt.
